# EUROPÄISCHE PATENTSCHRIFT

(11) **EP 0 545 077 B1**
(45) Veröffentlichungstag und Bekanntmachung des Hinweises auf die Patenterteilung: **03.01.2001**
(21) Anmeldenummer: 92118670.6
(22) Anmeldetag: 31.10.1992
(51) Int. Cl.: H03K 7/08

(54) **Vorrichtung zum Erzeugen eines impulsbreitenmodulierten Signals**
Device for generating a pulse-width modulated signal
Dispositif de génération d'un signal modulé en largeur d'impulsion

(30) Priorität: 06.12.1991 DE 4140290
(43) Veröffentlichungstag der Anmeldung: 09.06.1993
(73) Patentinhaber: ROBERT BOSCH GMBH, 70442 Stuttgart (DE)
(72) Erfinder: Peter, Cornelius, Dipl.-Ing., W-7583 Ottersweiher (DE); Voehringer, Klaus, Dipl.-Ing., W-7502 Malsch (DE); Spinner, Klaus, W-7580 Buehl-Neusatz (DE)

(56) Entgegenhaltungen:
- DE-A- 3 216 633
- FR-A- 2 662 315
- US-A- 4 585 960
- US-A- 4 656 460
- US-A- 4 847 695
- US-A- 4 891 828
- US-A- 5 063 489
- U.TIETZE & Ch.SCHENK. "Halbleiter-Schaltungstechnik", 1980, Springer Verlag, Berlin, Heidelberg, New York; Seiten 446 und 447
- O.MACEK, "Schaltnetzteile: Motorsteuerung und ihre speziellen Bauteile", 1982, Dr.Alfred Hüthig Verlag GmbH, Heidelberg, DE; Seiten 117-125

## Beschreibung

### Stand der Technik

Die Erfindung betrifft eine Vorrichtung zum Erzeugen eines höherfrequenteren impulsbreitenmodulierten Signals aus einem niederfrequenteren impulsbreitenmodulierten Signals.

Aus der DE-A 32 16 633 ist eine Schaltungsanordnung bekannt geworden, bei der ein von einer Signalquelle bereitgestelltes impulsbreitenmoduliertes Signal in ein höherfrequenteres impulsbreitenmoduliertes Signal mit gleichem Tastverhältnis zur Übertragung über einen Übertragungskanal umgesetzt wird. Sowohl das impulsbreitenmodulierte Signal der Signalquelle als auch das ausgangsseitige höherfrequentere impulsbreitenmodulierte Signal werden jeweils tiefpaßgefiltert und anschließend in einem Differenzverstärker miteinander verglichen. Am Ausgang des Differenzverstärkers steht ein Signal zur Verfügung, das einem Impulsdauermodulationseingang einer Zeitgeberschaltung zugeführt ist. Durch die Rückführung des höherfrequenten ausgangsseitigen impulsbreitenmodulierten Signals entsteht ein geschlossener Regelkreis, dem als Sollwert das eingangsseitige impulsbreitenmodulierte Signal zugeführt ist.

Aus der US-A 5 063 489 ist ein Schaltnetzteil bekannt, bei dem die Signalrückführung über einen Optokoppler realisiert ist. Die Ausgangsspannung des Schaltnetzteils wird mit einem Analog/Digital-Wandler in ein impulsbreitenmoduliertes Signal umgesetzt, das der Leuchtdiode des Optokopplers zugeführt wird. Das digitale Signal, das der Fotoempfänger des Optokopplers erfaßt, wandelt ein Digital/Analog-Wandler in ein entsprechendes analoges Signal zurück. Das analoge Signal wird danach wieder in ein impulsbreitenmoduliertes Signal zur Ansteuerung eines Schalttransistors im Primärkreis des Schaltnetzteils umgesetzt. Eine Änderung der Frequenz des über den Optokoppler übertragenen impulsbreitenmodulierten Signals gegenüber dem impulsbreitenmodulierten Ansteuersignal des Schalttransistors ist nicht relevant und demnach nicht vorgesehen. Das Tastverhältnis der beiden impulsbreitenmodulierten Signale kann voneinander abweichen, solange Veränderungen in beiden impulsbreitenmodulierten Signalen proportional zueinander sind.

Aus der FR-A 2 662 315 ist eine Pulsbreiten-Modulationsschaltung bekannt, bei der ein Mikroprozessor ein niederfrequentes impulsbreitenmoduliertes Signal vorgibt, das eine periphere Schaltungsanordnung in ein höherfrequentes impulsbreitenmoduliertes Signal umsetzt. Der Mikroprozessor stellt an einem Ausgang eine Folge von Logisch-H-Signalen und Logisch-L-Signalen bereit, aus denen ein nachgeschaltetes Schieberegister ein impulsbreitenmoduliertes Signal aufbereitet und an einem seriellen Ausgang bereitstellt. Das Schieberegister, dessen Inhalt durch den Mikroprozessor relativ langsam festgelegt wird, kann während des Auslesevorgangs mit seiner maximal zulässigen Betriebsfrequenz getaktet werden.

Aus der Firmenschrift von MOTOROLA Inc., Austin, Texas 78735, "Microprocessor Data", Vol. I, 1988, Seiten 3 - 773, 3 - 776 und 3 - 777 ist unter der Bezeichnung MC 68 HC 05 B6 ein Mikroprozessor bekannt geworden, der eine interne Struktur zur Ausgabe eines impulsbreitenmodulierten Signals enthält. Die Frequenz des Signals hängt von der Vorgabe durch das Programm und von der Taktfrequenz des Mikroprozessors ab. Die maximale Frequenz liegt bei einigen kHz.

Der Erfindung liegt die Aufgabe zugrunde, mit einfachen Mitteln die Erzeugung eines impulsbreitenmodulierten Signals zu ermöglichen, das gegenüber einem eingangsseitigen impulsbreitenmodulierten Signal eine höhere Frequenz aufweist.

Die Aufgabe wird durch die im unabhängigen Anspruch angegebenen Merkmale gelöst.

### Vorteile der Erfindung

Erfindungsgemäß ist vorgesehen, daß ein Mikroprozessor ein erstes impulsbreitenmoduliertes Signal abgibt, das eine erste Periodendauer aufweist, die durch die Arbeitsgeschwindigkeit des Mikroprozessors auf einen minimalen Wert begrenzt ist. Das erste impulsbreitenmodulierte Signal wird in ein Analogsignal umgesetzt, dessen Amplitude vom Verhältnis der Impulsdauer zur Impulspause des ersten impulsbreitenmodulierten Signals abhängt. Das analoge Signal wird mit einem sägezahnförmigen Signal, welches ein Generator bereitstellt, in einem Komparator verglichen. Die Periodendauer des sägezahnförmigen Signals ist kleiner als die des ersten impulsbreitenmodulierten Signals. Am Ausgang des Komparators ist das höherfrequente zweite impulsbreitenmodulierte Signal abgreifbar.

Eine kostengünstige Realisierung wird dadurch erreicht, daß der eingesetzte Mikroprozessor nicht speziell für die Ausgabe von impulsbreitenmodulierten Signalen vorbereitet zu sein braucht und deshalb kostengünstig erhältlich ist. Die damit verbundene Beschränkung der maximalen Frequenz des impulsbreitenmodulierten Signals wird durch die erfindungsgemäße Vorrichtung überwunden.

Vorteilhafte Weiterbildungen der erfindungsgemäßen Vorrichtung ergeben sich aus abhängigen Ansprüchen.

Das erste, von dem Mikroprozessor abgegebene impulsbreitenmodulierte Signal ist besonders kostengünstig mit einer Tiefpaßschaltung in das Analogsignal umsetzbar, dessen Amplitude vom Verhältnis der Impulsdauer zur Impulspause des ersten impulsbreitenmodulierten Signals abhängt.

Eine vorteilhafte Weiterbildung der erfindungsgemäßen Vorrichtung sieht vor, daß die Frequenz des Sägezahngenerators durch ein Steuersignal festlegbar ist, das vorzugsweise von der signalverarbeitenden Anordnung bereitgestellt wird. Mit dieser Maßnahme ist eine einfache Festlegung der Frequenz des zu erzeugenden, zweiten impulsbreitenmodulierten Signals möglich. Die erfindungsgemäße Vorrichtung ist besonders geeignet zur Verwendung in getakteten Stromversorgungen für die unterschiedlichsten Anwendungen. Weitere Ausgestaltungen und Weiterbildungen der erfindungsgemäßen Vorrichtung ergeben sich aus weiteren Unteransprüchen in Verbindung mit der folgenden Beschreibung.

### Zeichnung

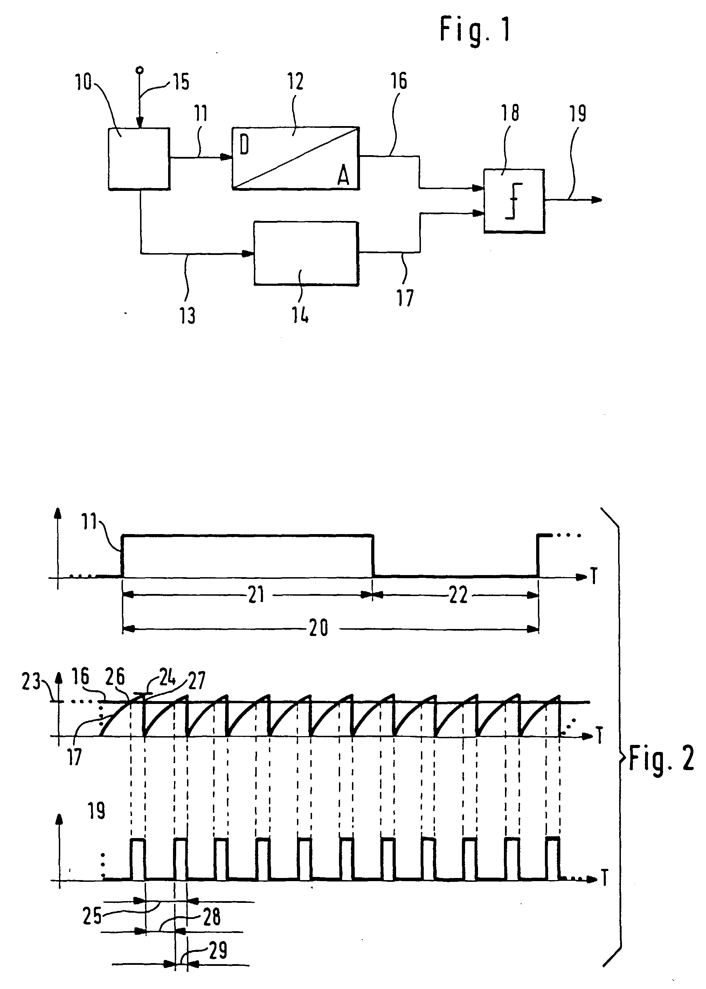

Figur 1 zeigt ein Blockschaltbild einer erfindungsgemäßen Vorrichtung zum Erzeugen eines impulsbreitenmodulierten Signals und Figur 2 zeigt Signalverläufe in Abhängigkeit von der Zeit, die in der Vorrichtung gemäß Figur 1 auftreten.

Figur 1 zeigt eine signalverarbeitende Anorndung 10, die ein erstes impulsbreitenmoduliertes Signal 11 an einen Digital/Analog-Wandler 12 und ein Steuersignal 13 an einen Sägezahngenerator 14 abgibt. Die signalverarbeitende Anorndung 10 erhält ein Eingangssignal 15 zugeführt.

Ein vom Digital/Analog-Wandler 12 abgegebenes Analogsignal 16 sowie ein vom Generator 14 abgegebenes Sägezahnsignal 17 wird jeweils einem Komparator 18 zugeführt, der ein zweites impulsbreitenmoduliertes Signal 19 abgibt.

Figur 2 zeigt Signalverläufe in Abhängigkeit von der Zeit T, die in der Vorrichtung gemäß Figur 1 auftreten. Die einzelnen Signale sind deshalb in Figur 2 mit denselben Bezugszeichen wie in Figur 1 bezeichnet. Im oberen Teil ist das erste impulsbreitenmodulierte Signal 11 gezeigt, das die signalverarbeitende Anordnung 10 abgibt. Das Signal 11 hat eine Frequenz, die sich aus der Periodendauer 20 ergibt. Die Periodendauer 20 ist zusammengesetzt aus der Impulsdauer 21 und der Impulspause 22. Im mittleren Teil sind das Analogsignal 16 und das Sägezahnsignal 17 wiedergegeben. Das Analogsignal 16 weist eine Amplitude 23 und das Sägezahnsignal eine Amplitude 24 auf. Die Frequenz des Sägezahnsignals 17 ergibt sich aus seiner Periodendauer 25. Das Analogsignal 16 und das Sägezahnsignal 17 weisen in jeder Periode 25 zwei Schnittpunkte 26, 27 auf.

Im unteren Teil von Figur 2 ist das zweite impulsbreitenmodulierte Signal 19 gezeigt, dessen Frequenz aus seiner Periodendauer ableitbar ist, die der Periodendauer 25 des Sägezahnsignals 17 entspricht. Die Periodendauer 25 des zweiten impulsbreitenmodulierten Signals 19 ist zusammengesetzt aus der Impulsdauer 28 und der Impulspause 29. Die Impulsdauer 29 beginnt jeweils bei dem ersten Schnittpunkt 26 und endet bei dem zweiten Schnittpunkt 27.

Die Funktion der in Figur 1 gezeigten Vorrichtung wird anhand der in Figur 2 gezeigten Signalverläufe näher erläutert:

Die signalverarbeitende Anordnung 10 gibt in Abhängigkeit von dem Eingangssignal 15 das erste impulsbreitenmoduierte Signal 11 ab, dessen Periodendauer 20 und somit dessen Frequenz entweder festgelegt oder variabel sein kann. Variabel ist das Verhältnis von Impulsdauer 21 zu Impulspause 22. Anstelle des Eingangssignals 15 kann auch ein fest vorgegebener Wert vorgesehen sein, der sich gegebenenfalls mit der Zeit ändert. Das Eingangssignal 15 ist in diesem Fall nicht erforderlich.

Die signalverarbeitende Anordnung 10 ist als Mikroprozessor realisiert, dem neben der Bereitstellung des ersten impulsbreitenmodulierten Signals 11 zahlreiche weitere Aufgaben zugeteilt sein können. Eine preisgünstige Realisierung der signalverarbeitenden Anordnung 10, beispielsweise durch einen Mikroprozessor, ist zumeist mit Einschränkungen in der minimal vorgebbaren Periodendauer 20 des ersten impulsbreitenmodulierten Signals 11 verbunden. Unter der Annahme, daß ein preisgünstiger Mikroprozessor weitere Funktionen erledigt, ist derzeit eine Frequenz des ersten impulsbreitenmodulierten Signals erreichbar, die bei einigen kHz liegt. In Abhängigkeit von der Anwendung, die beispielsweise bei getakteten Stromversorgungen gegeben ist, reicht die Frequenz nicht immer aus. Erfindungsgemäß sind deshalb die zusätzlichen Elemente 12, 14, 18 vorgesehen, die das erste impulsbreitenmodulierte Signal 11 in das zweite impulsbreitenmodulierte Signal 19 umsetzen, dessen Frequenz erheblich höher als die des ersten Signals 11 sein kann.

Das erste impulsbreitenmodulierte Signal 11 wird zunächst vom Digital/Analog-Wandler 12 in das Analogsignal 16 umgewandelt. Der Wandler 12 ist vorzugsweise als eine Tiefpaßschaltung realisiert, die preisgünstig herstellbar ist. Besonders einfach ist die Realisierung als passiver Tiefpaß 1. Ordnung mit einer Widerstands-Kondensator-Kombination. Das Analogsignal 16 wird im Komparator 18 mit dem Sägezahnsignal 17 verglichen, das der Generator 14 abgibt. Der Generator 14 ist beispielsweise in analoger Schaltungstechnik realisiert und gibt ein kontinuierliches analoges Signal 17 ab. Anstelle der Vorgabe eines kontinuierlichen analogen Signals ist auch eine Vorgabe eines stufenförmig verlaufenden Signals möglich, wobei der Generator 14 digitale Komponenten enthalten kann und als Treppenspannungsgenerator realisiert ist. Das sägezahnförmige Signal 17 wird damit durch das stufenförmige Signal nachgebildet.

In einer Weiterbildung ist die Frequenz des Sägezahnsignals 17 in Abhängigkeit von einem Eingangssignal des Generators 14 veränderbar. Als Eingangssignal ist beispielsweise das in Figur 1 gezeigte Steuersignal 13 vorgesehen, das von der signalverarbeitenden Anordnung 10 abgegeben wird. Eine einfache Realisierung des Generators 14 ist in dieser Weiterbildung als spannungsgesteuerter Oszillator möglich. Die Periodendauer 25 des Sägezahnsignals 17, die der Periodendauer des zweiten, zu erzeugenden impulsbreitenmodulierten Signals 19 entspricht, ist in weiten Grenzen beliebig vorgebbar. Die Periodendauer 25 der Signale 17, 19 kann ohne weiteres im Mikrosekundenbereich liegen, entsprechend einer Frequenz von einigen 100 kHz.

Die Umschaltzeitpunkte des Komparators 18 sind durch die Schnittpunkte 26, 27 des Analogsignals 16 mit dem Sägezahnsignal 17 gegeben. Durch eine geeignete Wahl des Spannungsbereichs des Analogsignals 16 in Abhängigkeit vom Verhältnis der Impulsdauer 21 zu Impulspause 22 des ersten impulsbreitenmodulierten Signals 11 und in Abhängigkeit vom Kurvenverlauf des Sägezahnsignals 17 sind Umsetzkennwerte zwischen dem ersten und zweiten impulsbreitenmodulierten Signal 11, 19 vorgebbar. Festlegbar ist sowohl die Umsetzung des Bereichs, innerhalb dem das Verhältnis von Impulsdauer 21 zu Impulspause 22 des ersten impulsbreitenmodulierten Signals 11 in Bezug auf die Impulsdauer 29 und die Impulspause 28 des zweiten impulsbreitenmodulierten Signals 19 liegen kann, als auch die Linearität des Verhältnisses.

## Patentansprüche

1. Vorrichtung zum Erzeugen eines impulsbreitenmodulierten Signals (19), mit einem Mikroprozessor (10), der ein erstes impulsbreitenmoduliertes Signal (11) abgibt, das eine erste Periodendauer (20) aufweist, die durch die Arbeitsgeschwindigkeit des Mikroprozessors (10) auf einen minimalen Wert begrenzt ist, mit einem Digital/Analog-Wandler (12), der das erste impulsbreitenmodulierte Signal (11) in ein analoges Signal (16) umsetzt, dessen Amplitude (23) vom Verhältnis der Impulsdauer (21) zur Impulspause (22) des ersten impulsbreitenmodulierten Signals (11) abhängt, mit einem Generator (14), der ein sägezahnförmiges Signal (17) abgibt, dessen Periodendauer (25) kleiner ist als die des ersten impulsbreitendmodulierten Signals (11) und mit einem Komparator (18), der aus dem analogen Signal (16) und dem sägezahnförmigen Signal (17) das zu erzeugende impulsbreitenmodulierte Signal (19) bildet.

2. Vorrichtung nach Anspruch 1, dadurch gekennzeichnet, daß der Digital/Analog-Wandler (12) als Tiefpaßschaltung realisiert ist.

3. Vorrichtung nach Anspruch 2, dadurch gekennzeichnet, daß ein Tiefpaß 1. Ordnung vorgesehen ist.

4. Vorrichtung nach Anspruch 3, dadurch gekennzeichnet, daß eine Widerstands-Kondensator-Kombination vorgesehen ist.

5. Vorrichtung nach einem der vorhergehenden Ansprüche, dadurch gekennzeichnet, daß der Sägezahngenerator (14) ein kontinuierliches analoges Sägezahnsignal (17) abgibt.

6. Vorrichtung nach einem der Ansprüche 1 bis 4, dadurch gekennzeichnet, daß der Generator (14) ein Sägezahnsignal (17) abgibt, das durch ein treppenförmiges Signal nachgebildet ist.

7. Vorrichtung nach einem der vorhergehenden Ansprüche, dadurch gekennzeichnet, daß die Periodendauer (25) des vom Generator (14) abgegebenen sägezahnförmigen Signals (17), die der Periodendauer (25) des zweiten, zu erzeugenden impulsbreitenmodulierten Signals (19) entspricht, mit einem Steuersignal (13) vorgebbar ist.

## Claims

1. Apparatus for producing a pulse-width-modulated signal (19), having a microprocessor (10) which emits a first pulse-width-modulated signal (11) which has a first period duration (20) which is limited to a minimum value by the operating speed of the microprocessor (10), having a digital/analogue converter (12) which converts the first pulse-width-modulated signal (11) into an analogue signal (16) whose amplitude (23) depends on the ratio of the pulse duration (21) to the pulse pause (22) of the first pulse-width-modulated signal (11), having a generator (14) which emits a sawtooth-waveform signal (17) whose period duration (25) is shorter than that of the first pulse-width-modulated signal (11), and having a comparator (18) which uses the analogue signal (16) and the sawtooth-waveform signal (17) to form the pulse-width-modulated signal (19) to be produced.

2. Apparatus according to Claim 1, characterized in that the digital/analogue converter (12) is in the form of a low-pass filter circuit.

3. Apparatus according to Claim 2, characterized in that a 1st-order low-pass filter is provided.

4. Apparatus according to Claim 3, characterized in that a resistor/capacitor combination is provided.

5. Apparatus according to one of the preceding claims, characterized in that the sawtooth-waveform generator (14) emits a continuous analogue sawtooth-waveform signal (17).

6. Apparatus according to one of Claims 1 to 4, characterized in that the generator (14) emits a sawtooth-waveform signal (17) which is simulated by a staircase-waveform signal.

7. Apparatus according to one of the preceding claims, characterized in that the period duration (25) of the sawtooth-waveform signal (17) emitted by the generator (14), and which corresponds to the period duration (25) of the second pulse-width-modulated signal (19) to be produced, can be preset by a control signal (13).

## Revendications

1. Dispositif pour générer un signal (19) modulé en largeur d'impulsion, comprenant
- un microprocesseur (10) fournissant un premier signal (11) modulé en largeur d'impulsion, ayant une première période (20) limitée par la vitesse de fonctionnement du microprocesseur (10) à une valeur minimale,
- un convertisseur numérique/analogique (12) convertissant le premier signal (11) modulé en largeur d'impulsion, en un signal analogique (16) dont l'amplitude (23) dépend du rapport de la durée d'impulsion (21) à la pause d'impulsion (22) du premier signal (11) modulé en largeur d'impulsion,
- un générateur (14) fournissant un signal en dents de scie (17) dont la période (25) est inférieure à celle du premier signal (11) modulé en largeur d'impulsion et
- un comparateur (18) formant, à partir du signal analogique (16) et du signal en dents de scie (17), le signal (19) modulé en largeur d'impulsion et que l'on veut obtenir.

2. Dispositif selon la revendication 1,
caractérisé en ce que
le convertisseur numérique/analogique (12) est un filtre passe-bas.

3. Dispositif selon la revendication 2,
caractérisé en ce que
le filtre passe-bas est un filtre du premier ordre.

4. Dispositif selon la revendication 3,
caractérisé en ce qu'
il comporte un montage résistance-condensateur.

5. Dispositif selon l'une quelconque des revendications précédentes,
caractérisé en ce que
le générateur de signal en dents de scie (14) donne un signal de dents de scie (17) analogique, continu.

6. Dispositif selon l'une des revendications 1 à 4,
caractérisé en ce que
le générateur (14) fournit un signal en dents de scie (17) engendré à partir d'un signal d'échelons.

7. Dispositif selon l'une des revendications précédentes,
caractérisé en ce qu'
un signal de commande (13) prédétermine la période (25) du signal en dents de scie (17) fourni par le générateur (14) correspondant elle-même à la période (25) du second signal (19) modulé en largeur d'impulsion et que l'on veut générer.
